# EUROPÄISCHE PATENTANMELDUNG

(11) **EP 0 580 036 A2**
(43) Veröffentlichungstag der Anmeldung: **26.01.1994**
(21) Anmeldenummer: 93110992.0
(22) Anmeldetag: 09.07.1993
(51) Int. Cl.: G03F 7/11, G03F 7/20

(54) **Verfahren zur Herstellung von Mikrostrukturkörpern**

(30) Priorität: 21.07.1992 DE 4223886
(71) Anmelder: BASF Aktiengesellschaft, D-67063 Ludwigshafen (DE)
(72) Erfinder: Hoessel, Peter, Dr., D-6707 Schifferstadt (DE); Harth, Klaus, Dr., D-6719 Altleiningen (DE); Hoffmann, Gerhard, Dr., D-6701 Otterstadt (DE); Hibst, Hartmut, Dr., D-6905 Schriesheim (DE)

(57) **Zusammenfassung**

Die Erfindung betrifft ein Verfahren zur Herstellung von Mikrostrukturkörpern mit Strukturtiefen von mehreren µm bis in den mm-Bereich durch bildmäßiges Bestrahlen von Polymeren, die auf elektrisch leitfähigen Trägern mittels einer Haftschicht aufgebracht sind, mit Synchrotronstrahlung und Entfernen der bildmäßig bestrahlten Bereiche, wobei die Haftschicht aus mindestens zwei unterschiedlichen chemischen Elementen besteht, die durch gleichzeitiges Aufdampfen oder Kathodenzerstäubung auf den leitfähigen Träger aufgebracht werden und vor dem Auftragen des Polymeren selektiv oder teilweise entfernt werden.

Das Verfahren eignet sich zur Herstellung von Mikrostrukturkörpern aus Metallen oder Kunststoff.

## Beschreibung

Die Erfindung betrifft ein Verfahren zur Herstellung von Mikrostrukturkörpern mit Strukturtiefen von mehreren µm bis in den mm-Bereich durch bildmäßiges Bestrahlen von Polymeren, die auf elektrisch leitfähigen Trägern mittels einer Haftschicht aufgebracht sind, mit Synchrotronstrahlung und Entfernen der bildmäßig bestrahlten Bereiche, wobei bestimmte Haftschichten verwendet werden, die vor dem Auftrag des Polymeren teilweise entfernt werden.

Die Entwicklung der Mikroelektronik hat gezeigt, daß die konsequente Miniaturisierung und Integration zu einer unüberschaubaren Vielfalt neuer Produkte mit entsprechenden Technologien führt. Die Mikroelektronik hat in wenigen Jahren gegenüber anderen Industriezweigen einen gewaltigen Vorsprung in der Miniaturisierung gewonnen. Inzwischen zeichnet sich ab, daß in Zukunft auch andere Mikrotechniken eine große Bedeutung erlangen werden, wobei insbesondere die Mikromechanik und die integrierte Optik zu erwähnen sind. Solche Techniken eröffnen in der Kombination mit der Mikroelektronik eine unvorstellbare Zahl neuer elektronischer, optischer, biologischer und mechanischer Funktionselemente.

Bei einer Massenfertigung von nichtelektronischen Bauelementen, Systemkomponenten und Subsystemen der Mikrotechnik wird man naturgemäß die außerordentlich leistungsfähigen Fertigungsmethoden der Halbleitertechnik in möglichst großem Umfang nutzen. Gleichzeitig muß man versuchen, klassische Methoden der Feinwerktechnik für die Mikromechanik zu ertüchtigen und mit entsprechend modifizierten Halbleiterfertigungsmethoden zu verschmelzen, um so die engen Grenzen der Siliciumplanartechnik verlassen und neue Gestaltungsmöglichkeiten erschließen zu können, die auf einer Vielfalt von Formen und Materialien aufbauen. Diese Forderung wird z.B. in hohem Maße durch das LIGA-Verfahren erfüllt, das auf den Fertigungsschritten
- Lithographie
- Galvanoformung und
- Abformung
aufgebaut und am Kernforschungszentrum Karlsruhe (KfK) entwickelt worden ist.

Interessante Mikrostrukturprodukte sind Sensoren zur Messung von Beschleunigung, Durchfluß, Ultraschall, Feuchte u.ä., Mikromotoren, mikropneumatische Bauelemente, Mikrostecker für die Mikroelektronik, mikrooptische Bauelemente, Faseroptiken, Mikroelektroden, Spinndüsen, Mikrofilter, Gleitlager, Membrane und vieles andere mehr.

Der wesentliche Fertigungsschritt des LIGA-Verfahrens ist die strukturgenaue Bestrahlung des eingesetzten Polymeren. Die prinzipielle Durchführbarkeit des LIGA-Verfahrens konnte anhand einfacher Mikrostrukturen mit einem speziell hergestellten Polymethylmethacrylat (im folgenden PMMA genannt) nachgewiesen werden.

Für die Herstellung komplexer dreidimensionaler Strukturen mit Strukturtiefen mit mehreren µm bis in den mm-Bereich nach dem oben genannten LIGA-Verfahren, muß das PMMA oder andere, z.B. in den Patentanmeldungen DE-A-41 07 662, DE-A-41 07 851 und DE-A-41 41 352 beschriebene röntgenlichtempfindliche spezielle Polymere auf eine leitfähige Trägerplatte aufgebracht werden.

Bisher wird im Prozeß als Haftschicht Titan verwendet, welches durch Bedampfen oder Besputtern auf einen Kupferträger aufgebracht und anschließend oberflächlich oxidiert wird (vgl. W. Ehrfeld, P. Bley, F. Götz, J. Mohr, D. Münchmeyer, W. Schelb, H.J. Baring, D. Beets, J. Vac. Sci. Technol. B6 (1) Jan/Feb 1988, S. 178).

Diese Verfahrensweise zeigte sich jedoch noch nicht optimal, da sowohl die Haftung der Polymeren auf der elektrisch leitfähigen Trägerplatte als auch die Startpunktdichte beim nachfolgenden Galvanikprozeß nur mäßig sind, die Reproduzierbarkeit der oberflächlich durch Oxidation erzeugten Haftschicht unzureichend ist und an der Grenzschicht von Polymer zu Titan bzw. Titanoxid es aufgrund der höheren Röntgenlichtabsorption von Titan zu einem sprunghaften Anstieg der abgelagerten Dosis und damit zu einer unerwünschten Wärmeentwicklung und zu Rückstreueffekten von Strahlung und Elektronen kommt.

Aufgabe der vorliegenden Erfindung war es, ein geeignetes Verfahren zu entwickeln, mit welchem die oben genannten Nachteile vermeidbar sind. Es sollte ein Verfahren gefunden werden, mit welchem geeignete und für das LIGA-Verfahren adaptierte Haftschichten auf einen metallischen Träger aufgebracht werden können.

Überraschend wurde gefunden, daß ein Verfahren, bei dem gleichzeitig mindestens zwei unterschiedliche chemische Elemente durch Aufdampfen oder Kathodenzerstäubung auf einen Metallträger abgeschieden werden und nachträglich eines der beiden selektiv oder zum Teil an der Oberfläche entfernt wird, Haftschichten ermöglicht, welche die oben genannten Nachteile nicht aufweisen.

Gegenstand der vorliegenden Erfindung ist ein Verfahren zur Herstellung von Mikrostrukturkörpern mit Strukturtiefen von mehreren µm bis in den mm-Bereich durch bildmäßiges Bestrahlen von Polymeren, die auf elektrisch leitfähigen Trägern mittels einer Haftschicht aufgebracht sind, mit Synchrotronstrahlung und Entfernen der bildmäßig bestrahlten Bereiche, das dadurch gekennzeichnet ist, daß die Haftschicht aus mindestens zwei unterschiedlichen chemischen Elementen besteht, die durch gleichzeitiges Aufdampfen oder Kathodenzerstäubung auf den leitfähigen Träger aufgebracht werden und anschließend mindestens eines der auf den elektrisch leitfähigen Träger aufgebrachten chemischen Elemente vor dem Auftragen des Polymeren selektiv oder teilweise entfernt wird.

Das teilweise bzw. selektive Entfernen des chemischen Elements kann durch Ätzen erfolgen. Das vollständige oder teilweise Entfernen eines der chemischen Elemente der Haftschicht kann chemisch mit Hilfe von anorganischen Säuren, basischen Verbindungen oder durch Plasmaätzverfahren erfolgen.

Die Schichtdicke der Haftschicht beträgt vorzugsweise 10⁻⁴ µm bis 10 µm.

Als chemische Elemente der Haftschicht kommen insbesondere Beryllium, Bor, Magnesium oder Aluminium in Kombination mit Kohlenstoff, Silicium, Titan oder Chrom in Frage.

Nach dem erfindungsgemäßen Verfahren lassen sich aus einem röntgenlichtempfindlichen Polymeren Mikrostrukturkörper mit Strukturtiefen zwischen 3 µm und 2000 µm und lateralen Abmessungen von unter 10 µm hergestellt.

Das erfindungsgemäße Verfahren eignet sich insbesondere dazu, anschließend die für das LIGA-Verfahren üblichen Galvanikprozeßschritte und Abformprozeßschritte durchzuführen und Mikrostrukturkörper aus Metallen oder Kunststoffen herzustellen.

Zum erfindungsgemäßen Verfahren ist im einzelnen folgendes auszuführen.

Als Träger kommen alle elektrisch leitfähigen Materialien in Frage, bevorzugt sind Metalle, z.B. Stahl, Nickel, Aluminium oder Kupfer; besonders bevorzugt ist Kupfer beispielsweise mit einer Schichtdicke von 8 mm. Als Träger kommen außerdem Siliciumwafer in Frage.

Die Schichtdicke der Haftschicht kann zwischen 10⁻⁴ µm und 10 µm, vorzugsweise 3 bis 6 µm betragen.

Zur Herstellung der Haftschichten kann eine Kombination aus zwei oder mehreren bei 20°C festen chemischen Elemente eingesetzt werden; bevorzugt ist eine Kombination aus festen und an Luft stabilen Elementen der 1. bis 3. Periode des chemischen Periodensystems; besonders bevorzugt ist eine Kombination aus Beryllium, Bor und/oder Magnesium und/oder Aluminium mit Kohlenstoff und/oder Silicium und/oder Titan und/oder Chrom.

Die erfindungsgemäße Herstellung der Haftschichten kann durch Aufdampfen, Lichtbogenbeschichtung oder chemische Gasphasenabscheidung oder in bevorzugter Weise durch Kathodenzerstäubung (Sputtern) erfolgen. Hierzu sind verschiedene methodische Varianten der Kathodenzerstäubung, wie Magnetron-Sputtern, DC- bzw. RF-Sputtern, Bias-Sputtern oder reaktives Sputtern sowie deren Kombinationen geeignet. Beim Magnetron-Sputtern befindet sich das zu zerstäubende Target in einem äußeren Magnetfeld, welches das Plasma in den Bereich des Targets konzentriert und damit eine Erhöhung der Zerstäubungsrate bewirkt. Beim DC- bzw. RF-Sputtern erfolgt die Anregung des Zerstäubungsplasmas in an sich bekannter Weise durch DC- bzw. RF-Generatoren. Beim Bias-Sputtern wird der zu beschichtende Formkörper mit einer in der Regel negativen Vorspannung (Bias) belegt, welche während der Beschichtung zu einem intensiven Beschuß des Formkörpers mit Ionen führt. Die Herstellung mehrkomponentiger metallischer Legierungen erfolgt dabei üblicherweise durch Einbringen eines geeigneten Targets in die Beschichtungsanlage und durch anschließendes Zerstäuben des Targets in einem Edelgasplasma, bevorzugt in Ar. Geeignete Targets sind entweder homogene Legierungstargets, die in bekannter Weise durch Schmelzverfahren bzw. durch pulvermetallurgische Methoden hergestellt werden, oder inhomogene Mosaiktargets, die durch Zusammenfügen kleinerer Teilstücke unterschiedlicher chemischer Zusammensetzung oder durch Auflegen bzw. Aufkleben von kleinen scheibenförmigen Materialstücken auf homogene Targets hergestellt werden. In alternativer Weise können metallische Legierungen dadurch hergestellt werden, daß zwei oder mehrere Targets unterschiedlicher Zusammensetzung gleichzeitig zerstäubt werden (simultanes Sputtern). DC- und RF-Generatoren sind Netzteile zum Erzeugen von Gleichspannungen (DC) oder Hochfrequenzspannungen (RF).

Das Ätzen der Haftschichten kann mit reaktiven Gasen, mit Plasma, elektrochemisch oder chemisch mit organischen oder anorganischen Säuren, Oxidationsmitteln oder basischen Reagenzien durchgeführt werden. Durch diesen Prozeß soll mindestens eines der in der Haftschicht befindlichen chemischen Elemente ganz oder zum Teil an der Oberfläche entfernt werden. Hierdurch entstehen Mikrohohlräume oder Mikrofehlstellen in der Haftschicht, welche als Haftanker für eine mechanische Verzahnung des Polymers dienen können.

Bevorzugt zum Ätzen sind Natronlauge und/oder HCl und/oder HF bei Al/Si-Schichten.

Zum Ätzen können auch Zinkatbeizen verwendet werden, um eine dünne Zinkschicht auf den Haftschichten zu erzeugen. Die Zinkatbeizen können aber auch als zusätzliche Nachbehandlung nach dem Ätzprozeß verwendet werden.

Die Zinkatbeizen enthalten beispielsweise neben Natriumhydroxid Zinksalze, z.B. Zinkcarbonat oder Zinkoxid und gegebenenfalls weitere Zusätze wie FeCl₂ und/oder Kaliumnatriumtartrat und/oder Natriumgluconat und/oder Salicylsäure.

Diese Nachbehandlung kann auch erst nach dem Laminieren, Bestrahlen und Entwickeln des Polymers in den Mikrostrukturen vor dem Galvanikprozeß durchgeführt werden, um eine Verbesserung der Haftung des Galvanikmetalls zu ermöglichen.

Als Polymere können alle für das LIGA-Verfahren geeignete Röntgenresiste eingesetzt werden; bevorzugt sind Resiste auf der Basis von Polymethylmethacrylat, Polyoxymethylene und aliphatische Polyester, z.B. Polylactide und Polylactid-co-glycolide.

Die Polymeren können nach dem Gießverfahren, einem Preßverfahren, durch Spritzguß oder durch eine Kombination aus Extrusion und Kalandrieren einer Polymerfolie auf den mit der Haftschicht beschichteten Träger aufgebracht werden.

Die in den Beispielen genannten Teile und Prozente sind, soweit nicht anders angegeben, Gewichtsteile bzw. Gewichtsprozente.

### Beispiel

A. Herstellung von Aluminium/Silicium-Haftschichten
   Ein poliertes Cu-Blech (Größe 100 x 70 mm², Dicke 1 mm) wurde in eine Kathodenzerstäubungsanlage eingebracht. Parallel zu dem Cu-Blech wurde in einem Abstand von 60 mm ein rundes Target (Durchmesser 200 mm) mit der Zusammensetzung Al₇₀Si₃₀ eingesetzt. Die Vakuumkammer der Kathodenzerstäubungsanlage wurde auf ein Vakuum von 5 x 10⁻⁷ mbar evakuiert. Danach wurde Argon bis zu einem Druck von 9 x 10⁻³ mbar eingelassen. Bei einer Substrattemperatur von 200°C wurde das Cu-Blech durch Anlegen einer RF-Spannung zunächst einer Sputterätzbehandlung unterzogen, wobei die negative Bias-Spannung, die sich auf dem Cu-Blech gegenüber Erdpotential einstellt, stufenweise in 30 V-Schritten von -90 V auf -180 V erhöht wurde (Intervalldauer jeweils 2 min). Nach Abschluß der Sputterätzbehandlung wurde der Ar-Druck auf 5 x 10⁻³ mbar reduziert. Durch Anlegen einer DC-Spannung (Leistung 500 W) an das Al₇₀Si₃₀-Target wurde auf dem Cu-Blech eine Schicht der Dicke 3,5 µm abgeschieden. Die Substrattemperatur wurde dabei auf 200°C und der RF-Bias des Substrats auf -90 V gehalten.
   Diese Aluminium/Silicium-Haftschicht wurde anschließend durch einminütiges Eintauchen in eine 10 %ige Natriumhydroxidlösung bei einer Temperatur von 25°C geätzt, in destilliertem Wasser gespült und getrocknet.
B. Herstellung, Synchrotronbestrahlung und Entwicklung von Polymer/Träger-Verbunden
   Ein handelsübliches Polymethylmethacrylat-Granulat mit einem mittleren Molekulargewicht von 300 000 wird in einer Schichtdicke von 200 µm auf eine 8 mm dicke Kupferplatte mit einer Oberflächenrauhigkeit unter 0,2 µm gepreßt. Die dafür verwendete Kupferplatte ist mit der wie unter (A) beschrieben, nachbehandelten Legierung aus Aluminium und Silicium in einer Schichtdicke von 3,5 µm beschichtet.
   Nach Synchrotronbestrahlung durch eine spezielle Röntgenmaske mit Säulenstrukturen (von 45 µm bis 5 µm Durchmesser) und nach der Entwicklung mit einem adaptierten Entwickler (GG-Entwickler, siehe DE 30 39 110 C2) erhält man Mikrostrukturen aus Polymethylmethacrylat, in welchen alle Säulen mit einem Durchmesser von 45 µm und von 18 µm stehen, von den Säulen mit einem Durchmesser von 8 µm noch 60 % und von den Säulen mit einem Durchmesser von 5 µm noch 25 % stehen.
   Anschließend können die im LIGA-Verfahren üblichen Folgeschritte Galvanoformung und Abformung durchgeführt werden.

### Vergleichsbeispiel

Ein handelsübliches Polymethylmethacrylat-Granulat mit einem mittleren Molekulargewicht von 300 000 wird in einer Schichtdicke von 200 µm auf eine 8 mm dicke Kupferplatte mit einer Oberflächenrauhigkeit unter 0,2 µm gepreßt. Die dafür verwendete Kupferplatte ist mit ca. 3,5 µm Titan beschichtet, welches anschließend oberflächlich mit Wasserstoffperoxid oxidiert wurde.

Nach Synchrotronbestrahlung durch eine spezielle Röntgenmaske mit Säulenstrukturen (von 45 µm bis 3 µm Durchmesser) und nach der Entwicklung mit einem adaptierten Entwickler (GG-Entwickler, s. DE 30 39 110 C2) erhält man Mikrostrukturen aus Polymethylmethacrylat.

Von Säulen mit einem Durchmesser von 45 µm stehen nur noch 40 % auf dem Träger, bei den restlichen ist Haftversagen aufgetreten. Von Säulen mit einem Durchmesser von 18 µm stehen nur noch 5 %. Kleinere Säulen sind nicht mehr vorhanden.

## Patentansprüche

1. Verfahren zur Herstellung von Mikrostrukturkörpern mit Strukturtiefen von mehreren µm bis in den mm-Bereich durch bildmäßiges Bestrahlen von Polymeren, die auf elektrisch leitfähigen Trägern mittels einer Haftschicht aufgebracht sind, mit Synchrotronstrahlung und Entfernen der bildmäßig bestrahlten Bereiche, dadurch gekennzeichnet, daß die Haftschicht aus mindestens zwei unterschiedlichen chemischen Elementen besteht, die durch gleichzeitiges Aufdampfen oder Kathodenzerstäubung auf den leitfähigen Träger aufgebracht werden und anschließend mindestens eines der auf den elektrisch leitfähigen Träger aufgebrachten chemischen Elemente vor dem Auftragen des Polymeren selektiv oder teilweise entfernt wird.

2. Verfahren nach Anspruch 1, dadurch gekennzeichnet, daß das teilweise Entfernen des chemischen Elements durch Ätzen erfolgt.

3. Verfahren nach einem der vorhergehenden Ansprüche, dadurch gekennzeichnet, daß die Schichtdicke der Haftschicht 10⁻⁴ µm bis 10 µm beträgt.

4. Verfahren nach einem der vorhergehenden Ansprüche, dadurch gekennzeichnet, daß als chemische Elemente der Haftschicht Beryllium, Bor, Magnesium oder Aluminium in Kombination mit Kohlenstoff, Silicium, Titan oder Chrom eingesetzt werden.

5. Verfahren nach einem der vorhergehenden Ansprüche, dadurch gekennzeichnet, daß das vollständige oder teilweise Entfernen eines der chemischen Elemente der Haftschicht chemisch mit Hilfe von anorganischen Säuren, basischen Verbindungen oder durch Plasmaätzverfahren erfolgt.

6. Verfahren nach Anspruch 5, dadurch gekennzeichnet, daß das vollständige oder teilweise Entfernen eines der chemischen Elemente der Haftschicht mit Hilfe von basischen Verbindungen unter Mitverwendung von Zinkatbeizen erfolgt.

7. Verfahren nach einem der vorhergehenden Ansprüche, dadurch gekennzeichnet, daß anstelle des elektrisch leitfähigen Trägers ein Siliciumwafer verwendet wird.

8. Verfahren nach einem der vorhergehenden Ansprüche, dadurch gekennzeichnet, daß aus einem röntgenlichtempfindlichen Polymeren Mikrostrukturkörper mit Strukturtiefen zwischen 3 µm und 2000 µm und lateralen Abmessungen von unter 10 µm hergestellt werden.

9. Verfahren nach einem der vorhergehenden Ansprüche, dadurch gekennzeichnet, daß anschließend die für das LIGA-Verfahren üblichen Galvanikprozeßschritte und Abformprozeßschritte durchgeführt und Mikrostrukturkörper aus Metallen oder Kunststoffen hergestellt werden.
